(19)

Europäisches Patentamt
European Patent Office
Office européen des brevets

(11) **EP 3 429 321 A1**

(12) **EUROPEAN PATENT APPLICATION**
published in accordance with Art. 153(4) EPC

(43) Date of publication:
**16.01.2019 Bulletin 2019/03**

(21) Application number: **17763299.9**

(22) Date of filing: **08.03.2017**

(51) Int Cl.:
**H05K 1/14** (2006.01)          **G06F 3/041** (2006.01)
**G06F 3/044** (2006.01)

(86) International application number:
**PCT/JP2017/009173**

(87) International publication number:
**WO 2017/154959 (14.09.2017 Gazette 2017/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **11.03.2016 JP 2016047909**

(71) Applicant: **Fujikura Ltd.**
**Tokyo 135-8512 (JP)**

(72) Inventor: **SUTO, Yuki**
**Sakura-shi**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

(54) **WIRING BODY ASSEMBLY, WIRING STRUCTURE, AND TOUCH SENSOR**

(57)     A tip end (51E) of a substrate (51) and a wall surface (31B) of a second support resin layer (31) are separated from each other so that a terminal portion (22C) includes an exposed portion exposed from the second support resin layer (31) and a conductive adhesive layer (80), a convex portion (82) and a sealing resin (90) are provided , the convex portion is formed on an upper surface of the second support resin layer (31) so as to be in contact with the tip end (51E) of the substrate (51) and to define a groove (86) together with an upper surface of a first support resin layer (21) and the wall surface (31B) of the second support resin layer (31), a sealing resin (90) fills between convex portion (82) and the second support resin layer (31) and covers the exposed portion of the terminal portion (22C), and a height (HI) from the upper surface of the first support resin layer (21) to a distal portion is comparatively higher than a height (H2) from the upper surface of the first support resin layer (21) to the upper surface of the substrate (51).

FIG. 4

EP 3 429 321 A1

## Description

TECHNICAL FIELD

The present invention relates to a wiring body assembly, a wiring structure, and a touch sensor.

For designated countries that are permitted to be incorporated by reference in the literature, the contents of Patent Application No. 2016-047909 filed with Japan Patent Office on March 11, 2016 is incorporated herein by reference and is regarded as a part of the description of this specification.

BACKGROUND ART

It is known that an exposed portion of a silver electrode terminal is sealed with a resin, as a connection structure between a silver electrode terminal and a flexible printed wiring board (hereinafter, referred to as an FPC) of a color plasma display panel (for example, refer to Patent Document 1).

CITATION LIST

PATENT DOCUMENT

Patent Document 1: JP 2001-15042 A

SUMMARY OF THE INVENTION

PROBLEM TO BE SOLVED BY THE INVENTION

Concerning a connection structure between a terminal portion of a wiring body which includes: a resin layer; and the terminal portion formed on the surface of the resin layer and a connection wiring body such as an FPC, in a case where the exposed portion of the terminal portion of the wiring body is sealed with a resin, it is possible to obtain a reinforcing effect of the wiring body by a sealing resin. Here, in a case where wet-spreading of the resin is not stable at the time of forming the sealing resin, a variation occurs in the thickness of sealing resin, and thus, a variation occurs in the strength of the wiring body in the vicinity of a connection portion with respect to the connection wiring body.

An object of the present invention is to provide a wiring body assembly, which is capable of stabilizing the strength of the wiring body in the vicinity of the connection portion with respect to the connection wiring body, a wiring structure, and a touch sensor.

MEANS FOR SOLVING PROBLEM

[1] A wiring body assembly according to the present invention is a wiring body assembly including: a wiring body including a first resin layer, a first terminal portion which is formed on one surface of the first resin layer, and a second resin layer which is formed on the one surface of the first resin layer so that the first terminal portion is exposed; a connection wiring body including a substrate, and a second terminal portion which is formed on one surface of the substrate and faces the first terminal portion; and a conductive adhesive layer which is formed between the first terminal portion and the second terminal portion and with which the first terminal portion and the second terminal portion adhere to each other, in which an end portion of the substrate and an end portion of the second resin layer are separated from each other so that the first terminal portion includes an exposed portion exposed from the second resin layer and the conductive adhesive layer, the wiring body assembly further includes: a convex portion which is formed on the one surface of the first resin layer so as to be in contact with the end portion of the substrate and to define a groove portion together with the one surface and the second resin layer, or which is formed on the other surface of the substrate; and a sealing resin which fills between the convex portion and the second resin layer and which covers the exposed portion of the first terminal portion, and a following Expression (1) is satisfied:

$$H1 > H2 \ldots(1)$$

where, H1 is a height from the one surface of the first resin layer to an distal end of the convex portion, and H2 is a height from the one surface of the first resin layer to the other surface of the substrate.

[2] In the wiring body assembly according to the present invention, the convex portion may be integrally formed with the conductive adhesive layer on the one surface of the first resin layer so as to be in contact with the end portion of the substrate, and the convex portion may be made of a conductive adhesive material of which the conductive adhesive layer is made.

[3] In the wiring body assembly according to the present invention, a following Expression (2) may be satisfied:

$$H3 \geq H1 \ldots(2)$$

where, H3 is a thickness of the second resin layer.

[4] In the wiring body assembly according to the present invention, the sealing resin may extend in a direction intersecting with the first terminal portion, and the convex portion may be formed along a direction in which the sealing resin extends.

[5] In the wiring body assembly according to the present invention, the convex portion may include: a first convex portion formed along the direction in which the sealing resin extends; and a second convex portion formed along an end portion of the substrate in a direction intersecting with the terminal portion.

[6] In the wiring body assembly according to the present invention, the second resin layer may include a cut-out portion in which the end portion of the substrate is disposed, the cut-out portion may include a corner portion, and the corner portion may be filled with the sealing resin.

[7] A wiring structure according to the present invention includes: the wiring body assembly described above ; and a support body disposed on at least one surface of the wiring body.

[8] A touch sensor according to the present invention includes the wiring structure described above.

EFFECT OF THE INVENTION

According to the present invention, it is possible to suppress a variation in the thickness of the sealing resin covering the exposed portion of the first terminal portion, and thus, it is possible to stabilize a reinforcing effect of the first resin layer by the sealing resin. Accordingly, it is possible to stabilize the strength of the wiring body in the vicinity of the connection portion with respect to the connection wiring body.

BRIEF DESCRIPTION OF DRAWINGS

Fig. 1 is a plan view illustrating a touch sensor in one embodiment of the present invention.
Fig. 2 is an exploded perspective view illustrating the touch sensor.
Fig. 3 is a plan view enlargedly illustrating a connection portion between the touch sensor and a connection wiring body.
Fig. 4 is a cross-sectional view along line VI-VI of Fig. 3.
Fig. 5 is a cross-sectional view along line V-V of Fig. 3.
Fig. 6 is a cross-sectional view for illustrating a connection method between a first wiring body and the connection wiring body.
Fig. 7 is a cross-sectional view for illustrating the connection method between the first wiring body and the connection wiring body.
Fig. 8 is a graph illustrating a relationship between a width d of a conductive adhesive material and a height H1 of a convex portion.
Fig. 9 is a cross-sectional view for illustrating the connection method between the first wiring body and the connection wiring body.
Fig. 10 is a cross-sectional view enlargedly illustrating the connection portion between the touch sensor and the connection wiring body in a comparative example.
Fig. 11 is a cross-sectional view enlargedly illustrating the connection portion between the touch sensor and the connection wiring body in another embodiment.
Fig. 12 is a cross-sectional view enlargedly illustrating the connection portion between the touch sensor and the connection wiring body in another embodiment.
Fig. 13 is a cross-sectional view enlargedly illustrating the connection portion between the touch sensor and the connection wiring body in another embodiment.
Fig. 14 is a plan view enlargedly illustrating the connection portion between the touch sensor and the connection wiring body in another embodiment.

MODE(S) FOR CARRYING OUT THE INVENTION

Hereinafter, embodiments of the present invention will be described on the basis of the drawings.

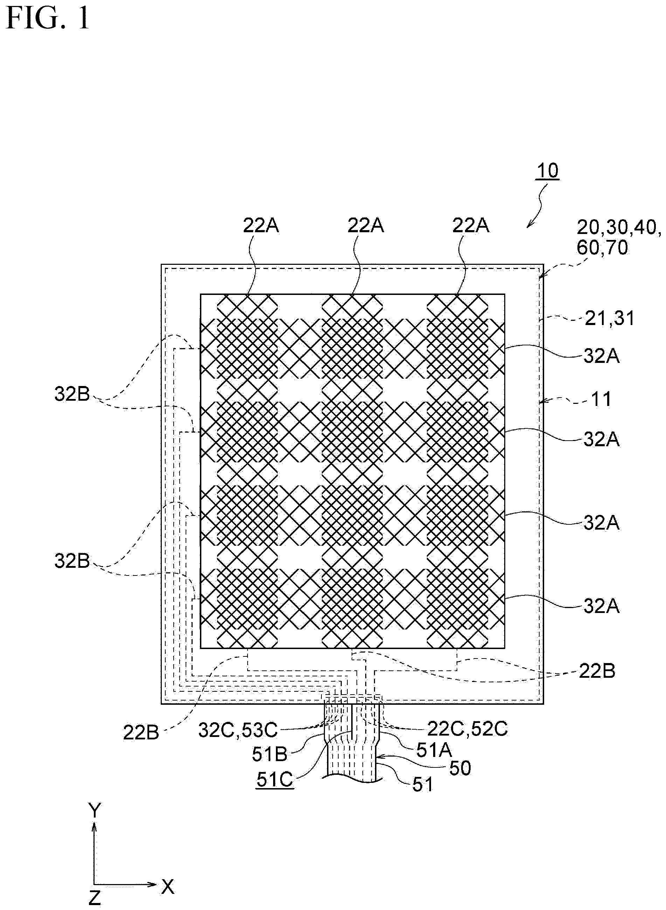

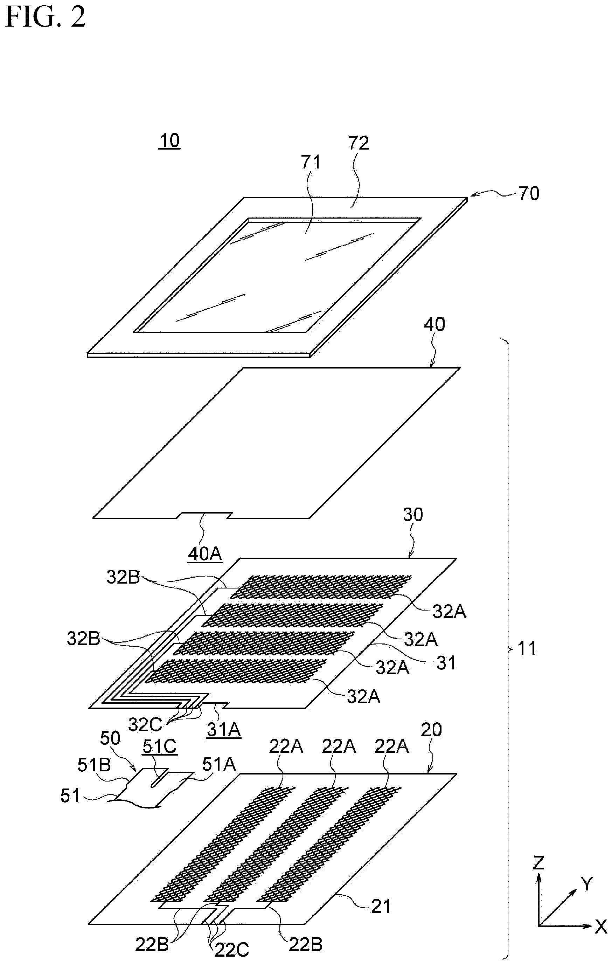

Fig. 1 is a plan view illustrating a touch sensor 10 in one embodiment of the present invention, and Fig. 2 is an exploded perspective view illustrating the touch sensor 10. The touch sensor 10 illustrated in Fig. 1 and Fig. 2 is a projection electrostatic capacitance type touch panel sensor, and for example, is used as an input device having a function of detecting a touch position by being combined with a display device (not illustrated) or the like. The display device is not particularly limited, but a liquid crystal display, an organic EL display, electronic paper or the like can be used. The touch sensor 10 includes a detection electrode and a driving electrode disposed to face each other (an electrode 22A and an electrode 32A described below), and a predetermined voltage is periodically applied between two electrodes from an external circuit (not illustrated) through a connection wiring body 50.
In such a touch sensor 10, for example, in a case where a finger of a operator (an external conductor) is close to the touch sensor 10, a capacitor (electrostatic capacitance) is formed between the external conductor and the touch sensor 10, and an electrical state between two electrodes is changed. The touch sensor 10 is capable of detecting an operating position of the operator on the basis of an electrical change between two electrodes.
As illustrated in Fig. 1 and Fig. 2, the touch sensor 10 includes a wiring body assembly 11 and a cover panel 70. The wiring body assembly 11 includes a first wiring body 20, a second wiring body 30 which is disposed on the first wiring body 20, a coating resin layer 40 which is disposed on the second wiring body 30, and a connection wiring body 50. The first wiring body 20, the second wiring body 30 and the coating resin layer 40 are configured to have transparency (light transmittance) as a whole in order to ensure visibility of the display device.

The first wiring body 20 includes a first support resin layer 21 which is formed in a rectangular shape, and a plurality of electrodes 22A for detection, a plurality of lead-out wires 22B and a plurality of terminal portions 22C which are formed on an upper surface of the first support resin layer 21.

The first support resin layer 21 is made of a resin material having transparency. For example, an UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified as the resin material having transparency.

The electrode 22A is in a reticular shape. Each of the electrodes 22A extends in a Y direction of the drawing, and the plurality of electrodes 22A are parallel in an X direction of the drawing. One end of each of the lead-out wires 22B is connected to one longitudinal direction end of each of the electrodes 22A. Each of the lead-out wires 22B extends from the one longitudinal direction end of each of the electrodes 22A to the connection portion with respect to the connection wiring body 50. Each of the terminal portions 22C is disposed on the other end of each of the lead-out wires 22B, and the terminal portion 22C is electrically connected to the connection wiring body 50.

The electrode 22A, the lead-out wire 22B and the terminal portion 22C are made of a conductive material (conductive particles) and a binder resin. A metal material such as silver, copper, nickel, tin, bismuth, zinc, indium and palladium, and a carbon-based material such as graphite, carbon black (furnace black, acetylene black and ketchen black), a carbon nanotube and a carbon nanofiber can be exemplified as the conductive material. A metal salt may be used as the conductive material. A salt of the metal described above can be exemplified as the metal salt. An acrylic resin, a polyester resin, an epoxy resin, a vinyl resin, a urethane resin, a phenolic resin, a polyimide resin, a silicone resin, a fluorine resin and the like can be exemplified as the binder resin. The electrode 22A, the lead-out wire 22B and the terminal portion 22C are formed by being coated with a conductive paste and curing the conductive paste. A conductive paste which is obtained by mixing the conductive material and the binder resin described above, with water or a solvent, and various additives, can be exemplified as a specific example of the conductive paste. $\alpha$-Terpineol, butyl carbitol acetate, butyl carbitol, 1-decanol, butyl cellosolve, diethylene glycol monoethyl ether acetate, tetradecane and the like can be exemplified as the solvent contained in the conductive paste. The binder resin may be omitted from the material configuring the electrode 22A, the lead-out wire 22B and the terminal portion 22C.

The number of electrodes 22A of the first wiring body 20 is not particularly limited, and can be arbitrarily set. The number of lead-out wires 22B and the number of terminal portions 22C of the first wiring body 20 are set according to the number of electrodes 22A.

The second wiring body 30 includes a second support resin layer 31 which is formed in a rectangular shape, and a plurality of electrodes 32A for detection, a plurality of lead-out wires 32B and a plurality of terminal portions 32C which are formed on an upper surface of the second support resin layer 31. The second support resin layer 31 is formed to cover the upper surface of the first support resin layer 21, the electrode 22A and the lead-out wire 22B. Here, the rectangular cut-out portion 31A is formed on one side of the second support resin layer 31, a part of the first wiring body 20 including the connection portion with respect to the connection wiring body 50 is exposed from the second support resin layer 31 through the cut-out portion 31A, and an exposed portion is the terminal portion 22C.

The second support resin layer 31 is made of a resin material having transparency. For example, an UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified as the resin material having transparency.

The electrode 32A is in a reticular shape. Each of the electrodes 32A extends in the Y direction of the drawing, and the plurality of electrodes 32A are parallel in the X direction of the drawing. One end of each of the lead-out wires 32B is connected to one longitudinal direction end of each of the electrodes 32A. Each of the lead-out wires 32B extends from the one longitudinal direction end of each of the electrodes 32A to the connection portion with respect to the connection wiring body 50. Each of the terminal portions 32C is disposed on the other end of each of the lead-out wires 32B, and the terminal portion 32C is electrically connected to the connection wiring body 50.

The electrode 32A, the lead-out wire 32B and the terminal portion 32C are made of a conductive material (conductive particles) and a binder resin. A metal material such as silver, copper, nickel, tin, bismuth, zinc, indium and palladium, and a carbon-based material such as graphite, carbon black (furnace black, acetylene black, ketchen black), a carbon nanotube and a carbon nanofiber can be exemplified as the conductive material. A metal salt may be used as the conductive material. A salt of the metal described above can be exemplified as the metal salt. An acrylic resin, a polyester resin, an epoxy resin, a vinyl resin, a urethane resin, a phenolic resin, a polyimide resin, a silicone resin, a fluorine resin and the like can be exemplified as the binder resin. The electrode 32A, the lead-out wire 32B and the terminal portion 32C are formed by being coated with a conductive paste and by curing the conductive paste. A conductive paste which is obtained by mixing the conductive material and the binder resin described above, with water or a solvent, and various additives, can be exemplified as a specific example of the conductive paste. $\alpha$-Terpineol, butyl carbitol acetate, butyl carbitol, 1-decanol, butyl cellosolve, diethylene glycol monoethyl ether acetate, tetradecane and the like can be exemplified as the solvent contained in the conductive paste. The binder resin may be omitted from the material configuring the electrode 32A, the lead-out wire 32B and the terminal portion 32C.

The number of electrodes 32A of the second wiring body 30 is not particularly limited, and can be arbitrarily set. The number of lead-out wires 32B and the number of terminal portions 32C of the second wiring body 30 are set according to the number of electrodes 32A.

The coating resin layer 40 is formed in a rectangular shape, the coating resin layer 40 is formed to cover the upper surface of the second support resin layer 31, the electrode 32A and the lead-out wire 32B of the second wiring body 30. Here, a rectangular cut-out portion 40A is formed on one side of the coating resin layer 40, a part of the second wiring body 30 including the connection portion with respect to the connection wiring body 50 is exposed from the second support resin layer 31 through the cut-out portion 40A, and a portion which is exposed is the terminal portion 32C. A part of the first wiring body 20 including the connection portion with respect to the connection wiring body 50 is also exposed from the coating resin layer 40 through the cut-out portion 40A.

The coating resin layer 40 is made of a resin material having transparency. For example, an UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified as the resin material having transparency. The coating resin layer 40 may be a multi-layer. In this case, the first layer positioned on the second wiring body 30 side may be formed of the UV curable resin, the thermosetting resin, the thermoplastic resin and the like such as the epoxy resin, the acrylic resin, the polyester resin, the urethane resin, the vinyl resin, the silicone resin, the phenolic resin and the polyimide resin described above, and the second layer positioned on a side opposite to the second wiring body 30 (the cover panel 70 side) may be an adhesive layer by using a known adhesive agent such as a silicon resin-based adhesive agent, an acrylic resin-based adhesive agent, a urethane resin-based adhesive agent and a polyester resin-based adhesive agent.

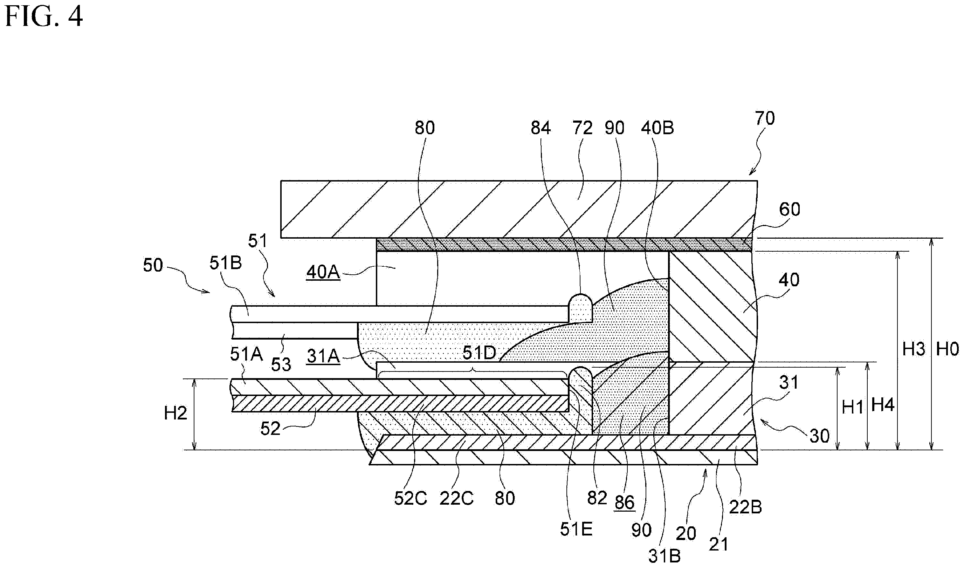

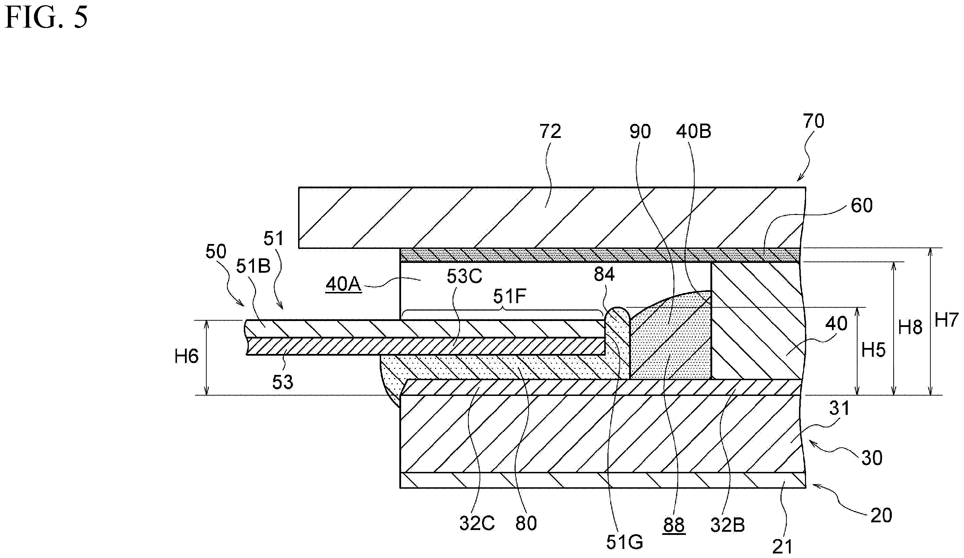

The cover panel 70 adheres to an upper surface of the coating resin layer 40 through a transparent adhesive layer 60 (refer to Fig. 4 and Fig. 5). The transparent adhesive layer 60 is an optical transparent adhesive film, and can be formed by using a known adhesive agent such as a silicon resin-based adhesive agent, an acrylic resin-based adhesive agent, a urethane resin-based adhesive agent and a polyester resin-based adhesive agent. Here, in this embodiment, the transparent adhesive layer 60 is formed on a lower surface of the cover panel 70 in advance, but in a case where the coating resin layer 40 has a multi-layered structure and a layer of the coating resin layer 40 on the cover panel 70 side is an adhesive layer, it is not necessary to form the transparent adhesive layer 60, and thus, the transparent adhesive layer 60 may be omitted. In this embodiment, the transparent adhesive layer 60 is formed on the lower surface of the cover panel 70 in advance, and thus, the transparent adhesive layer 60 exists on the cut-out portions 31A and 40A. However, in a case where the coating resin layer 40 has a multi-layered structure and the layer of the coating resin layer 40 on the cover panel 70 side is an adhesive layer, the adhesive layer may not exist on the cut-out portions 31A and 40A.

The cover panel 70 includes: a transparent portion 71 which is capable of transmitting a visible light ray; and a shielding portion 72 which shields a visible light ray. The transparent portion 71 is formed in a rectangular shape, and the shielding portion 72 is formed around the transparent portion 71 in the shape of a rectangular frame. For example, a glass material such as soda lime glass and borosilicate glass, and a resin material such as polymethyl methacrylate (PMMA) and polycarbonate (PC) can be exemplified as a transparent material configuring the cover panel 70. The shielding portion 72 is formed in an outer circumference portion on a rear surface of the cover panel 70, for example, by being coated a black ink.

The connection wiring body 50 is an FPC and includes a strip-like substrate (base material) 51, and a plurality of wirings 52 and a plurality of wirings 53 which are formed on a lower surface of the substrate 51. The substrate 51 can be configured of a film material made of, for example, polyethylene terephthalate (PET), polyethylene naphthalate (PEN), a polyimide resin (PI), a polyether imide resin (PEI) and the like.

A slit 51C is formed in a central portion in a width direction of one longitudinal direction end of the substrate 51, and the one longitudinal direction end of the substrate 51 is divided by the slit 51C in the width direction. One end of the plurality of wirings 52 is disposed on a lower surface on one side (a first branch portion 51A) of the one longitudinal direction end of the substrate 51, and one end of the plurality of wirings 53 is disposed on a lower surface on the other side (a second branch portion 51B) of the one longitudinal direction end of the substrate 51 .

The plurality of wirings 52 are disposed corresponding to the plurality of lead-out wires 22B of the first wiring body 20. The plurality of wirings 52 are parallel to each other. A terminal portion 52C corresponding to the terminal portion 22C of the lead-out wire 22B is disposed on one end of each of the wirings 52.

The plurality of wirings 53 is disposed corresponding to the plurality of lead-out wires 32B of the second wiring body 30. The plurality of wirings 53 are parallel to each other. A terminal portion 53C corresponding to the terminal portion 32C of the lead-out wire 32B is disposed on one end of each of the wirings 53. A material configuring the wirings 52 and 53 is not particularly limited, and the same material as the material of the lead-out wires 22B and 32B may be used.

The connection wiring body 50 is not limited to the FPC, and for example, may be the other wiring board such as a rigid substrate or a rigid flexible substrate.

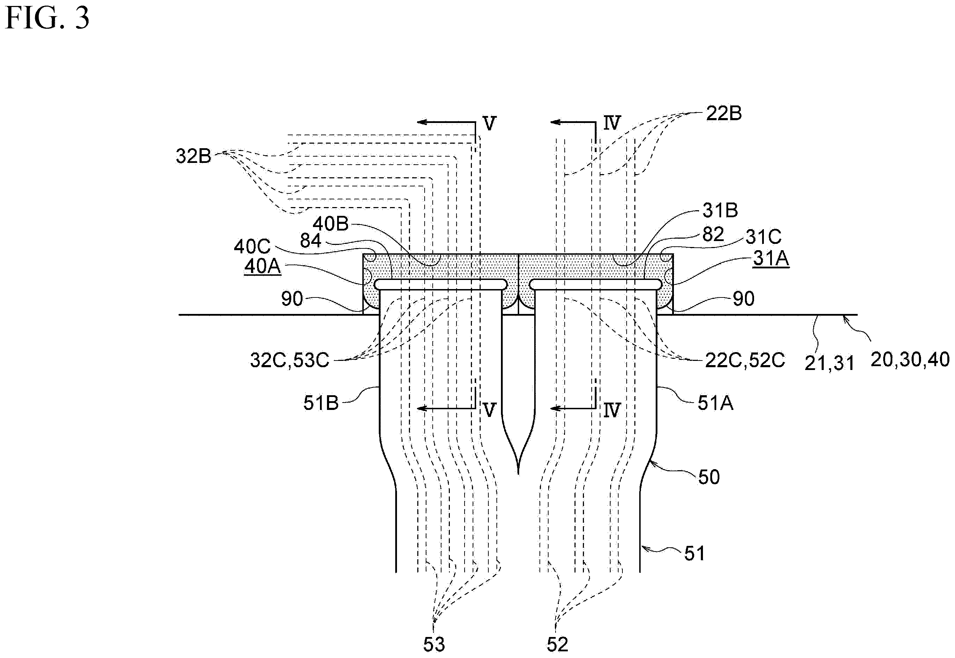

Fig. 3 is a plan view enlargedly illustrating a connection portion between the touch sensor 10 and the connection wiring body 50, Fig. 4 is a cross-sectional view along line IV-IV of Fig. 3, and Fig. 5 is a cross-sectional view along line V-V of Fig. 3. As illustrated in Fig. 3 and Fig. 4, an adhesive portion 51D of the first branch portion 51A on a tip end side and a region of the first support resin layer 21 in the cut-out portion 31A vertically face each other through the conductive adhesive layer 80, and adhere to each other with the conductive adhesive layer 80. The terminal portion 52C of the wiring 52 and the terminal portion 22C of the lead-out wire 22B vertically face each other through the conductive adhesive layer 80.

The conductive adhesive layer 80 has a function of electrically and mechanically connecting the terminal portion 52C and the terminal portion 22C to each other. In addition, the conductive adhesive layer 80 has a function of insulating the terminals adjacent to each other. An anisotropic conductive film (ACF), an anisotropic conductive paste (ACP) and the like can be exemplified as such a conductive adhesive layer 80.

The terminal portion 52C and the terminal portion 22C may be electrically and mechanically connected to each other with using a metal paste such as a silver paste or a solder paste, without using the anisotropic conductive material. In this case, it is necessary to form a plurality of adhesive layers with an interval such that the adjacent terminals are insulated.

The second support resin layer 31 is formed with an interval with respect to the adhesive portion 51D of the first branch portion 51A. Accordingly, through the cut-out portion 31A, the upper surface of the first support resin layer 21 and the terminal portion 22C of the first wiring body 20 are exposed from the first branch portion 51A, the conductive adhesive layer 80 and the second support resin layer 31.

A height H4 from the upper surface of the first support resin layer 21 to the upper surface of the second support resin layer 31 is comparatively higher than a height H2 from the upper surface of the first support resin layer 21 to an upper surface of the adhesive portion 51D of the first branch portion 51A. It is not essential that the height H4 is comparatively higher than the height H2 as long as a height H0 from the upper surface of the first support resin layer 21 to an upper surface of the transparent adhesive layer 60 and a height H3 from the upper surface of the first support resin layer 21 to the upper surface of the coating resin layer 40 satisfy a relationship of Expression (2') described below and Expression (2) described below.

A convex portion 82 is formed on the upper surface of the first support resin layer 21 along a tip end 51E of the first branch portion 51A from one end to the other end of the tip end 51E. The convex portion 82 is integrally formed with the conductive adhesive layer 80 by the conductive adhesive material of which the conductive adhesive layer 80 is made.

The convex portion 82 protrudes from the upper surface of the first support resin layer 21 so as to be in contact with the tip end 51E of the first branch portion 51A. It is preferable that a height H1 from the upper surface of the first support resin layer 21 to a distal end of the convex portion 82 and the height H2 from the upper surface of the first support resin layer 21 to the upper surface of the adhesive portion 51D of the first branch portion 51A satisfy a relationship of Expression (1) described below.

$$H1 > H2 \ \dots(1)$$

It is preferable that the height H0 from the upper surface of the first support resin layer 21 to the upper surface of the transparent adhesive layer 60 and the height H1 from the upper surface of the first support resin layer 21 to the distal end of the convex portion 82 satisfy a relationship of Expression (2') described below, thereby the convex portion 82 is not in contact with the cover panel 70. It is preferable that the height H1 and the height H3 from the upper surface of the first support resin layer 21 to the upper surface of the coating resin layer 40 satisfy a relationship of Expression (2) described below.

$$H0 \geq H1 \ \dots(2')$$

$$H3 \geq H1 \ \dots(2)$$

The convex portion 82 is formed to extend in parallel with a wall surface 31B of the second support resin layer 31 (a depth direction of a paper surface of Fig. 4, and a direction parallel to a extending direction of the tip end 51E), and a groove 86 is formed by the convex portion 82, the wall surface 31B and the upper surface of the first support resin layer 21. The groove 86 is filled with a sealing resin 90, and an exposed portion of the terminal portion 22C which is exposed from the first branch portion 51A, the conductive adhesive layer 80, the convex portion 82 and the second support resin layer 31 is sealed with the sealing resin 90. Accordingly, the entire terminal portion 22C of the first wiring body 20 is coated with a resin, and thus, a defect due to the exposure does not occur in the terminal portion 22C of the first wiring body 20. Here, in a case where the conductive adhesive layer 80 is formed by curing a liquid conductive adhesive agent, the convex portion 82 which is in contact with the end portion of the substrate 51 and defines the groove 86 together with the upper surface of the first support resin layer 21 and the wall surface 31B of the second support resin layer 31 is not formed. In contrast, in this embodiment, the conductive adhesive layer 80 is formed by using an anisotropic conductive film or an anisotropic conductive paste of which a viscosity is adjusted, and thus, the convex portion 82 can be formed so as to be in contact with the end portion of the substrate 51 and to define the groove 86 together with the upper surface of the first support resin layer 21 and the wall surface 31B of the second support resin layer 31.

The sealing resin 90 extends from one end to the other end of the groove 86 and has a function of reinforcing a region of the first support resin layer 21 between the convex portion 82 and the wall surface 31B of the second support resin layer 31. Accordingly, reliability in a mechanical strength of the terminal portion 22C and the lead-out wire 22B is improved. The sealing resin 90 protrudes from both ends of the groove 86 and spreads to both sides of the adhesive portion 51D in the longitudinal direction. Then, the corner portion 31C of the cut-out portion 31A and a corner portion 40C of the cut-out portion 40A are also filled with the sealing resin 90.

An UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified as a resin material configuring the sealing resin 90.

As illustrated in Fig. 3 and Fig. 5, an adhesive portion 51F of the second branch portion 51B on the tip end side and a region of the coating resin layer 40 in the cut-out portion 40A vertically face each other through the above-described conductive adhesive layer 80 and adhere to each other with the conductive adhesive layer 80. The terminal portion 53C of the wiring 53 and the terminal portion 32C of the lead-out wire 32B vertically face each other through the conductive adhesive layer 80 and are electrically and mechanically connected to each other with the conductive adhesive layer 80.

The coating resin layer 40 is formed with an interval with respect to the adhesive portion 51F of the second branch portion 51B. Accordingly, the upper surface of the second support resin layer 31 and the terminal portion 32C of the second wiring body 30 are exposed from the second branch portion 51B, the conductive adhesive layer 80 and the coating resin layer 40 through the cut-out portion 40A.

A height H8 from the upper surface of the second support resin layer 31 to the upper surface of the coating resin layer 40 is comparatively higher than a height H6 from the upper surface of the second support resin layer 31 to the upper surface of the adhesive portion 51D of the first branch portion 51A. It is not essential that the height H8 is comparatively higher than the height H6, as long as a height H7 from the upper surface of the second support resin layer 31 to the upper surface of the transparent adhesive layer 60 and the height H8 from the upper surface of the second support resin layer 31 to the upper surface of the coating resin layer 40 satisfy a relationship of Expression (4) described below and Expression (5) described below.

A convex portion 84 is formed on the upper surface of the second support resin layer 31 along a tip end 51G of the second branch portion 51B from one end to the other end of the tip end 51G. The convex portion 84 is integrally formed with the conductive adhesive layer 80 by the conductive adhesive material of which the conductive adhesive layer 80 is made.

The convex portion 84 protrudes from the upper surface of the second support resin layer 31 so as to be in contact with the tip end 51G of the second branch portion 51B. It is preferable that a height H5 from the upper surface of the second support resin layer 31 to a distal end of the convex portion 84 and the height H6 from the upper surface of the second support resin layer 31 to the upper surface of the adhesive portion 51F of the second branch portion 51B satisfy a relationship of Expression (3) described below.

$$H5 > H6 \ldots(3)$$

It is preferable that the height H7 from the upper surface of the second support resin layer 31 to the upper surface of the transparent adhesive layer 60 and the height H5 from the upper surface of the second support resin layer 31 to the distal end of the convex portion 84 satisfy a relationship of Expression (4) described below, thereby the convex portion 84 is not in contact with the cover panel 70. It is preferable that the height H5 and the height H8 from the upper surface of the second support resin layer 31 to the upper surface of the coating resin layer 40 satisfy a relationship of Expression (5) described below.

$$H7 \geq H5 \ldots(4)$$

$$H8 \geq H5 \ldots(5)$$

The convex portion 84 is formed to extend in parallel with a wall surface 40B of the coating resin layer 40 (a depth direction of a paper surface of Fig. 5, and a direction parallel to a extending direction of the tip end 51G), and a groove 88 is formed by the convex portion 84, the wall surface 40B and the upper surface of the second support resin layer 31. The groove 88 is filled with the sealing resin 90, and an exposed portion of the terminal portion 32C which is exposed from the second branch portion 51B, the conductive adhesive layer 80, the convex portion 84 and the coating resin layer 40 is sealed with the sealing resin 90. Accordingly, the entire terminal portion 32C of the second wiring body 30 is coated with a resin, and thus, a defect due to the exposure does not occur in the terminal portion 32C of the second wiring body 30. Here, in a case where the conductive adhesive layer 80 is formed by curing a liquid conductive adhesive agent, the convex portion 84 which is in contact with the end portion of the substrate 51 and defines the groove 88 together with the upper surface of the second support resin layer 31 and the wall surface 40B of the coating resin layer 40 is not formed. In contrast, in this embodiment, the conductive adhesive layer 80 is formed by using an anisotropic conductive film or an anisotropic conductive paste of which a viscosity is adjusted, and thus, the convex portion 84 can be formed so as to be in contact with the end portion of the substrate 51 and to define the groove 88 together with the upper surface of the second support resin layer 31 and the wall surface 40B of the coating resin layer 40.

The sealing resin 90 extends from one end to the other end of the groove 88 and has a function of reinforcing a region of the second support resin layer 31 between the convex portion 84 and the wall surface 40B of the coating resin layer 40. Accordingly, reliability in a mechanical strength of the terminal portion 32C and the lead-out wire 32B is improved. The sealing resin 90 may protrude from both ends of the groove 88 and may spread to both sides of the adhesive portion 51D in the longitudinal direction.

Hereinafter, a connection method between the touch sensor 10 and the connection wiring body 50 will be described. Since a connection method between the first wiring body 20 and the connection wiring body 50 is similar to a connection method between the second wiring body 30 and the connection wiring body 50, the description of the connection method of the latter will be omitted, and the description of the connection method of the former will be quoted.

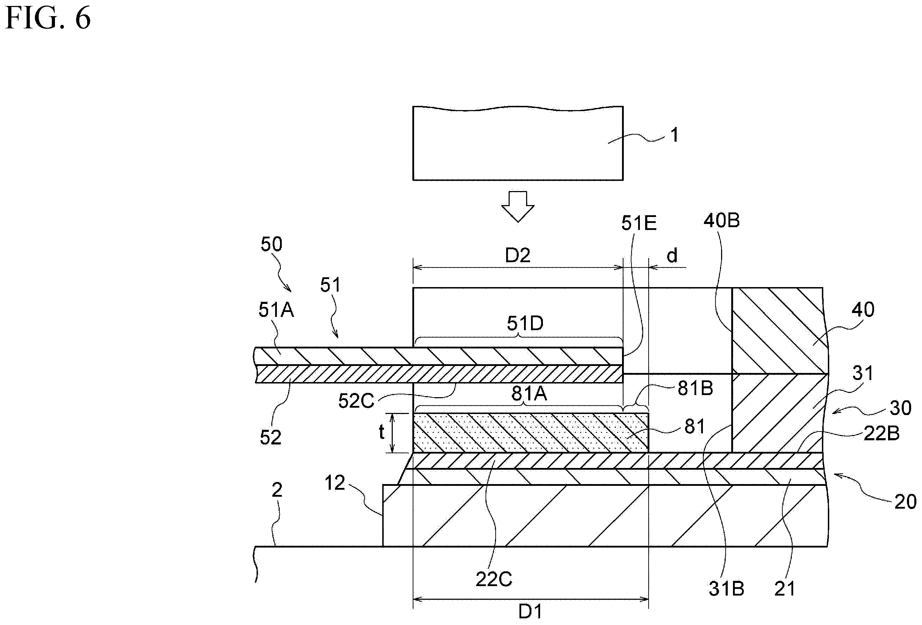

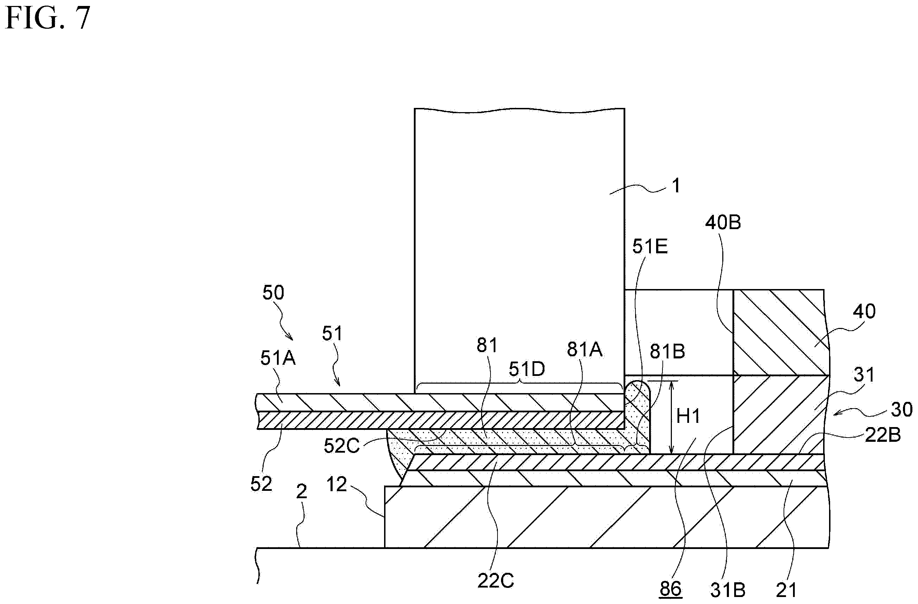

Fig. 6 and Fig. 7 are cross-sectional views for illustrating the connection method between the first wiring body 20 and the connection wiring body 50. As illustrated in Fig. 6 and Fig. 7, the convex portion 82 is formed at the same time of thermo-compression bonding the terminal portion 52C of the connection wiring body 50 and the terminal portion 22C of the first wiring body 20 through the conductive adhesive layer 80. A substrate 12 is disposed on the lower surface of the first support resin layer 21 at the time of manufacturing the touch sensor 10.

First, as illustrated in Fig. 6, a conductive adhesive material 81 such as ACF or ACP configuring the conductive adhesive layer 80 is disposed at an adhesive region of the first support resin layer 21. Here, a width D1 of the conductive adhesive material 81 is set to be wider than a width D2 of the adhesive portion 51D of the first branch portion 51A. Accordingly, the conductive adhesive material 81 includes: a region 81A interposed between the adhesive portion 51D of the first branch portion 51A and the first support resin layer 21; and a region 81B having a width d and protruding from the adhesive portion 51D of the first branch portion 51A

A thickness t of the conductive adhesive material 81 is set to be comparatively thicker than a thickness which adhesion of the terminal portion 52C and the terminal portion 22C requires. For example, in a case where the thickness of the substrate 51 is 30 μm and the thickness of the wiring 52 is 35 μm, the thickness t of the conductive adhesive material 81 is set to 35 μm.

Next, as illustrated in Fig. 7, the adhesive portion 51D of the first branch portion 51A and the adhesive region of the first support resin layer 21 are thermo-compression bonded with a compression head 1 and a compression base 2 in a state where the conductive adhesive material 81 is interposed between the adhesive portion 51D of the first branch portion 51A and the adhesive region of the first support resin layer 21. Here, at the time of thermo-compression bonding, a thickness of a region 81A of the conductive adhesive material 81 is reduced, whereas a region 81B of the conductive adhesive material 81 protrudes so as to be in contact with a side surface of the tip end 51E of the first branch portion 51A and the compression head 1. Accordingly, the convex portion 82 protruding from the upper surface of the first support resin layer 21 to the height H1 of exceeding the upper surface of the adhesive portion 51D of the first branch portion 51A is formed.

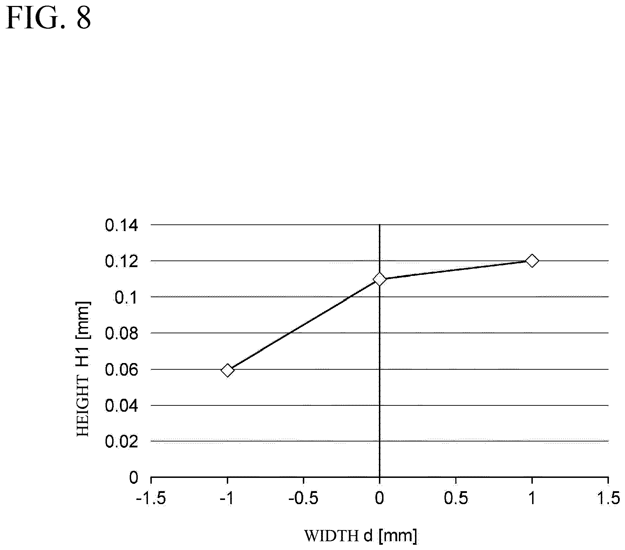

Fig. 8 is a graph illustrating a test result of confirming a relationship between a width d of the region 81B of the conductive adhesive material 81 and the height H1 of the convex portion 82. As illustrated in the graph, it is confirmed that the height H1 of the convex portion 82 tends to increase as the width d of the region 81B of the conductive adhesive material 81 increases. In this confirmation test, an anisotropic conductive film (a thickness of 35 μm) of a model number of CP801CM-35C manufactured by Dexerials Corporation is used, the width and the interval of the terminal portion 52C are respectively set to 0.2 mm, the thickness of the substrate 51 is set to 30 μm, and the thickness of the terminal portion 52C is set to 35 μm.

The terminal portion 52C of the connection wiring body 50 and the terminal portion 22C of the first wiring body 20 are thermo-compression bonded through the conductive adhesive material 81 and the convex portion 82 is formed, and then the sealing resin 90 is formed. In this process, the groove 86 formed by the convex portion 82, the wall surface 31B of the second support resin layer 31 and the upper surface of the first support resin layer 21 is filled with a liquid resin, and the liquid resin is cured. In the filling of the liquid resin, the liquid resin is dropped into the groove 86 by using a dispenser, and the dropped liquid resin spreads in the entire groove 86.

Here, the liquid resin at the time of filling tends to wet-spread not only in an extending direction of the sealing resin 90 but also in the width direction. However, since the convex portion 82 exists on one side of the sealing resin 90 in the width direction and the second support resin layer 31 and the coating resin layer 40 exist on the other side, the liquid resin at the time of filling is blocked by the convex portion 82, the second support resin layer 31 and the coating resin layer 40, and the wet-spreading of the liquid resin at the time of filling in the width direction is restricted. Accordingly, the liquid resin at the time of filling wet-spreads in the extending direction in a state where the width is constant, and a deposition height in the groove 86 increases.

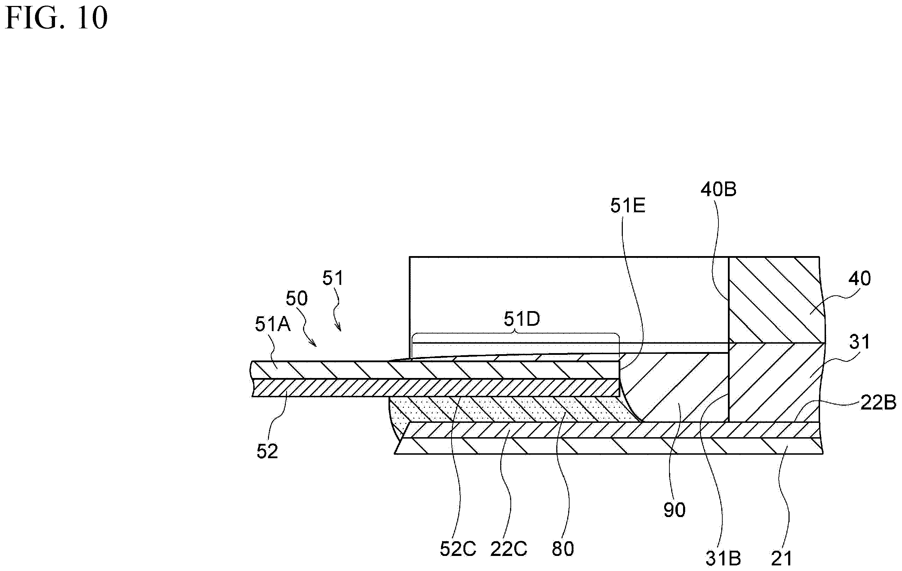

Fig. 10 is a cross-sectional view enlargedly illustrating the connection portion between the touch sensor 10 and the connection wiring body 50 in a comparative example. As illustrated in Fig. 10, in this comparative example, the convex portion 82 described above is not provided. For this reason, when the sealing resin 90 is formed, the liquid resin at the time of filling wet-spreads on the first branch portion 51A.

Here, it is not easy to control the wet-spreading of the liquid resin at the time of filling, and thus, it is not easy to control the thickness of the liquid resin filling between the tip end 51E of the first branch portion 51A and the wall surface 31B of the second support resin layer 31. For this reason, in the extending direction of the sealing resin 90, a variation occurs in the thickness of the sealing resin 90 covering the first support resin layer 21. Accordingly, a variation occurs in a reinforcing effect of the first support resin layer 21 by the sealing resin 90. In addition, a portion which is comparatively thinner than a desired thickness is formed in the sealing resin 90, and thus, the reinforcing effect of the first support resin layer 21 by the sealing resin 90 decreases. Further, in a case where the sealing resin 90 has fluidity due to heat or the like, the sealing resin 90 spreads on the first branch portion 51A.

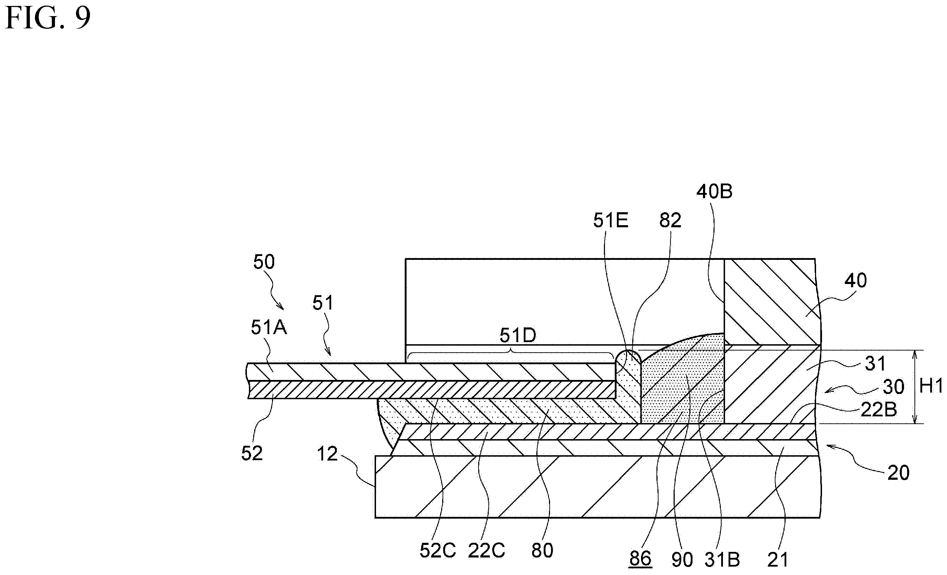

In contrast, in this embodiment, as illustrated in Fig. 4 or Fig. 9, the height H1 from upper surface of the first support resin layer 21 to the distal end of the convex portion 82 is set to be higher than the height H2 from the upper surface of the first support resin layer 21 to the upper surface of the adhesive portion 51D of the first branch portion 51A, and thus, the liquid resin at the time of filling is blocked by the convex portion 82, the second support resin layer 31 and the coating resin layer 40, and the wet-spreading of the sealing resin 90 in the width direction is restricted. Accordingly, the thickness of the liquid resin filling between the tip end 51E of the first branch portion 51A and the wall surface 31B of the second support resin layer 31 is easily controlled. Accordingly, in the extending direction of the sealing resin 90, the occurrence of a variation in the thickness of the sealing resin 90 covering the first support resin layer 21 can be suppressed, and thus, the occurrence of the variation in the reinforcing effect of the first support resin layer 21 by the sealing resin 90 can be suppressed. In addition, the entire sealing resin 90 can be formed to have a desired thickness, and thus, it is possible to improve the reinforcing effect of the first support resin layer 21 by the sealing resin 90. Further, even in a case where the sealing resin 90 has fluidity due to heat or the like, the sealing resin 90 is blocked by the convex portion 82, the second support resin layer 31 and the coating resin layer 40, and thus, the wet-spreading of the sealing resin 90 in the width direction is restricted. Similarly, concerning the second wiring body 30, as illustrated in Fig. 5, the height H5 from the upper surface of the second support resin layer 31 to the distal end of the convex portion 84 is set to be higher than the height H6 from the upper surface of the second support resin layer 31 to the upper surface of the adhesive portion 51F of the second branch portion 51B, and thus, the same effect as the effect of the first wiring body 20 described above is obtained.

In this embodiment, the convex portion 82 is integrally formed with the conductive adhesive layer 80 on the upper surface of the first support resin layer 21 so as to be in contact with the tip end 51E of the first branch portion 51A, and the convex portion 82 is made of the conductive adhesive material of which the conductive adhesive layer 80 is made. As described above, the convex portion 82 of such a configuration can be formed at the same time of thermo-compression bonding the terminal portion 52C of the connection wiring body 50 and the terminal portion 22C of the first wiring body 20 through the conductive adhesive material 81. Accordingly, a separate process for forming the convex portion 82 is not necessary, and thus, it is possible to reduce man-hour. In addition, since a gap is not formed between the convex portion 82 and the conductive adhesive layer 80 and the entire sealing resin 90 can be formed to have a desired thickness, and thus, it is possible to improve the reinforcing effect of the first support resin layer 21 by the sealing resin 90. Similarly, concerning the second wiring body 30, the convex portion 84 is integrally formed with the conductive adhesive layer 80 on the upper surface of the second support resin layer 31 so as to be in contact with the tip end 51G of the second branch portion 51B, and the convex portion 84 is made of the conductive adhesive material of which the conductive adhesive layer 80 is made, and thus, the same effect as the effect of the first wiring body 20 described above is obtained.

In this embodiment, a thickness H3 of the second support resin layer 31 and the coating resin layer 40 formed on the first support resin layer 21 is set to be higher than or equal to the height H1 from the upper surface of the first support resin layer 21 to the distal portion of the convex portion 82. Accordingly, when the sealing resin 90 is formed, the liquid resin at the time of filling can be prevented from wet-spreading on the upper surface of the coating resin layer 40. In addition, the sealing resin 90 does not protrude from the upper surface of the coating resin layer 40, and thus, when the cover panel 70 or the like adheres to the upper surface of the coating resin layer 40, it is possible to prevent the sealing resin 90 from becoming an obstacle, and it is possible to prevent an unnecessary stress from being generated. Similarly, concerning the second wiring body 30, a thickness H8 of the coating resin layer 40 formed on the second support resin layer 31 is set to be higher than or equal to the height H5 from the upper surface of the second support resin layer 31 to the distal portion of the convex portion 84, and thus, the same effect as the effect of the first wiring body 20 described above is obtained.

In this embodiment, the corner portion 31C of the cut-out portion 31A and the corner portion 40C of the cut-out portion 40A are filled with the sealing resin 90, and thus, in a case where a temperature cycle is applied to the second support resin layer 31 or the coating resin layer 40, it is possible to prevent a crack from occurring in the corner portion 31C of the cut-out portion 31A or the corner portion 40C of the cut-out portion 40A.

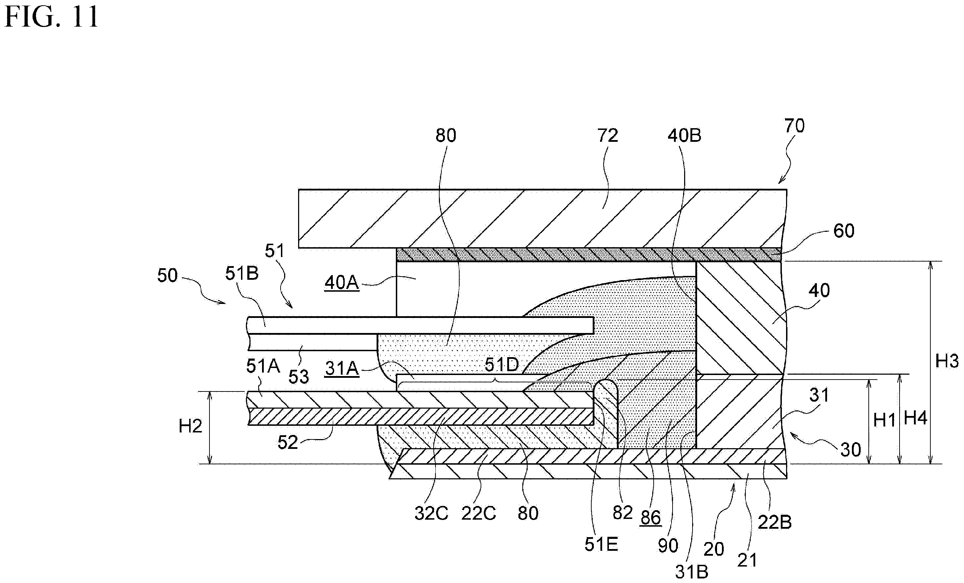

Fig. 11 is a cross-sectional view enlargedly illustrating the connection portion between the touch sensor 10 and the connection wiring body 50 in another embodiment. The same reference numerals will be applied to the same configurations as those of the embodiment described above, the repeated description will be omitted, and the description of the embodiment described above will be quoted.

As illustrated in Fig. 11, concerning the connection portion between the touch sensor 10 and the connection wiring body 50 in this embodiment, the groove 86 formed by the convex portion 82, the wall surfaces 31B and 40B and the upper surface of the first support resin layer 21 is filled with the sealing resin 90, and a part of the first branch portion 51A is coated with one end side of the sealing resin 90 in the width direction. That is, comparing to the embodiment described above, the thickness of the sealing resin 90 covering the first support resin layer 21 increases, and the one end side of the sealing resin 90 in the width direction spreads up to the first branch portion 51A in a state of being covered with the convex portion 82.

In this embodiment, the sealing resin 90 also has a function of reinforcing an adhesive region of the first support resin layer 21 with respect to the adhesive portion 51D of the first branch portion 51A, in addition to the function of reinforcing the region of the first support resin layer 21 between the convex portion 82 and the wall surfaces 31B and 40B. Accordingly, it is possible to improve reliability of connection between the terminal portion 22C and the terminal portion 52C.

Here, in this embodiment, the convex portion 82 exists on the one side of the sealing resin 90 in the width direction, and the second support resin layer 31 and the coating resin layer 40 exist on the other side, and thus, the liquid resin at the time of filling reliably fills up to the height of the convex portion 82. Accordingly, in the extending direction of the sealing resin 90, it is possible to prevent a variation from occurring in the thickness of the sealing resin 90 covering the first support resin layer 21, and to prevent a variation from occurring in the reinforcing effect of the first support resin layer 21 by the sealing resin 90.

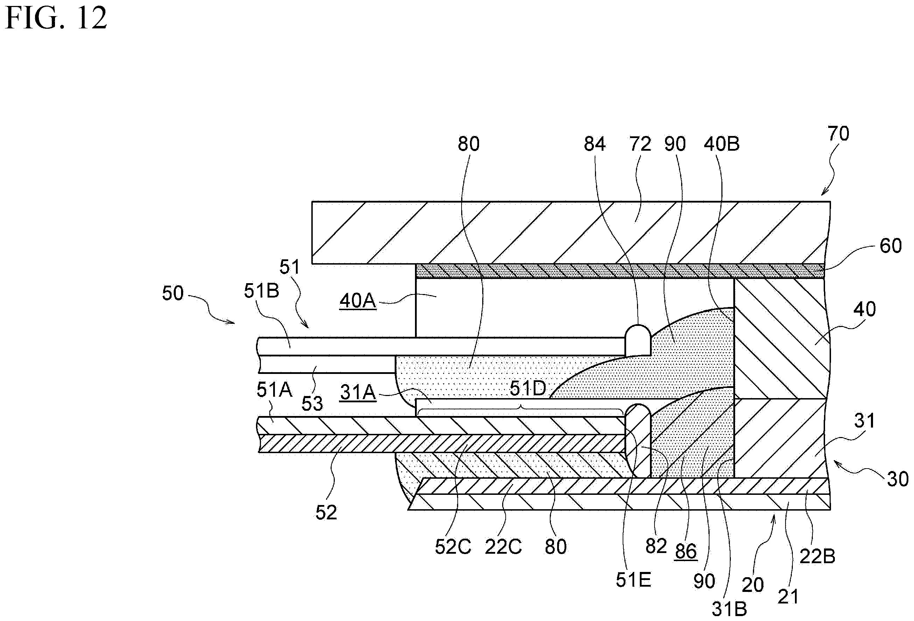

Fig. 12 is a cross-sectional view enlargedly illustrating the connection portion between the touch sensor 10 and the connection wiring body 50 in another embodiment. The same reference numerals will be applied to the same configurations as those of the embodiment described above, the repeated description will be omitted, and the description of the embodiment described above will be quoted.

As illustrated in Fig. 12, concerning the connection portion between the touch sensor 10 and the connection wiring body 50 in this embodiment, the convex portion 82 is formed separately from the conductive adhesive layer 80. Various resin material having insulating properties can be used as a material of which the convex portion 82 of this embodiment is made, and for example, an UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified. The groove 86 formed by the convex portion 82, the wall surfaces 31B and 40B and the upper surface of the first support resin layer 21 is filled with the sealing resin 90.

A formation method of the convex portion 82 of this embodiment will be described. In this embodiment, the convex portion 82 is formed after the terminal portion 52C of the connection wiring body 50 and the terminal portion 22C of the first wiring body 20 are thermo-compression bonded through the conductive adhesive layer 80.

First, the resin material is applied along the tip end 51E of the first branch portion 51A by using a dispenser. At this time, a deposition height of the resin material is comparatively higher than the height of the upper surface of the adhesive portion 51D of the first branch portion 51A. Then, the resin material is cured by a method of heating, irradiation of an ultraviolet ray or the like. Accordingly, the convex portion 82 protruding from the upper surface of the first support resin layer 21 to a height exceeding the upper surface of the adhesive portion 51D of the first branch portion 51A is formed.

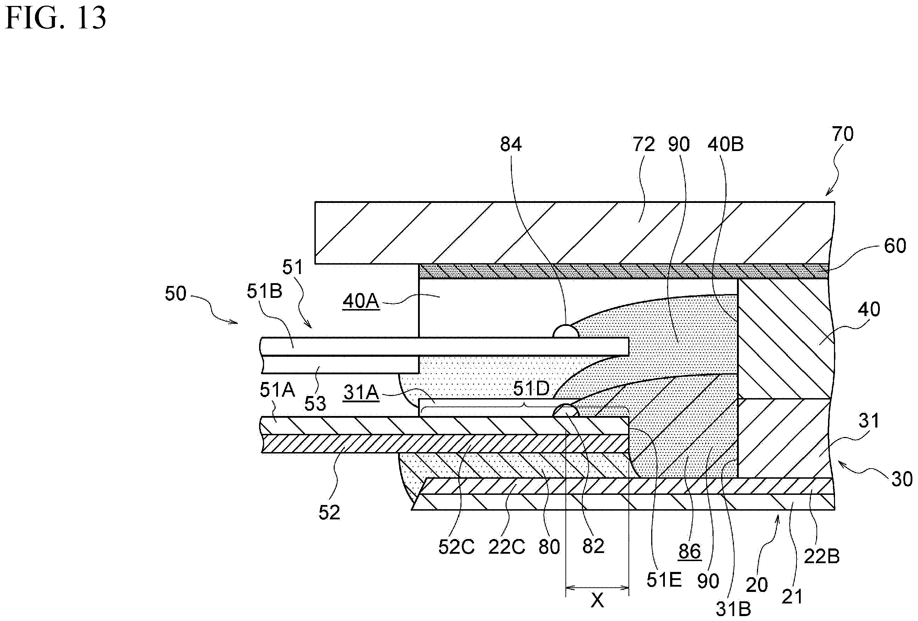

Fig. 13 is a cross-sectional view enlargedly illustrating the connection portion between the touch sensor 10 and the connection wiring body 50 in another embodiment. The same reference numerals will be applied to the same configurations as those of the embodiment described above, the repeated description will be omitted, and the description of the embodiment described above will be quoted.

As illustrated in Fig. 13, concerning the connection portion between the touch sensor 10 and the connection wiring body 50 in this embodiment, the convex portion 82 is formed on the adhesive portion 51D of the first branch portion 51A. The convex portion 82 is formed to extend in parallel with the tip end 51E of the first branch portion 51A. A distance X between the convex portion 82 and the tip end 51E may be suitably set, and for example, the distance X may be 0. For example, an UV curable resin, a thermosetting resin, a thermoplastic resin and the like such as an epoxy resin, an acrylic resin, a polyester resin, a urethane resin, a vinyl resin, a silicone resin, a phenolic resin and a polyimide resin can be exemplified as the material of which the convex portion 82 of this embodiment is made.

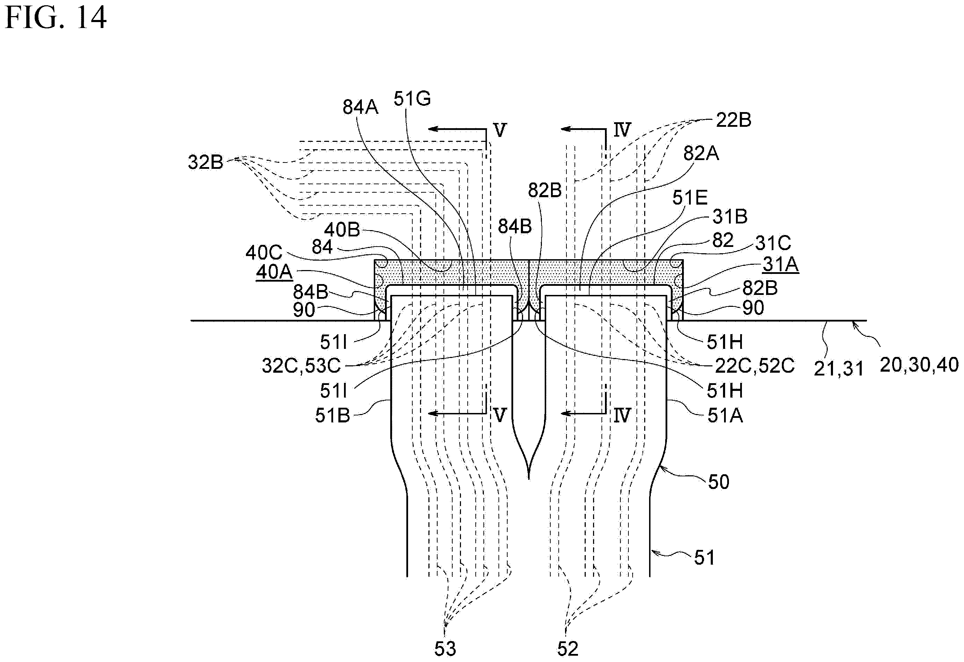

Fig. 14 is a plan view enlargedly illustrating the connection portion between the touch sensor 10 and the connection wiring body 50 in another embodiment. The same reference numerals will be applied to the same configurations as those of the embodiment described above, the repeated description will be omitted, and the description of the embodiment described above will be quoted.

As illustrated in Fig. 14, concerning the connection portion between the touch sensor 10 and the connection wiring body 50 in this embodiment, the convex portion 82 includes: a first convex portion 82A which is formed from one end to the other end of the tip end 51E along the tip end 51E of the first branch portion 51A; and second convex portions 82B which are formed on both ends of the first convex portion 82A in the extending direction. The second convex portions 82B are formed on the upper surface of the first support resin layer 21 along end portions 51H on both sides of the first branch portion 51A in the width direction (a direction orthogonal to the terminal portion 52C). That is, the convex portion 82 extends along an end surface of a tip end of the first branch portion 51A and is formed so as to reach the end surface of the first branch portion 51A on both sides in the width direction. Accordingly, on both sides of the first branch portion 51A in the width direction, the wet-spreading of the liquid resin at the time of filling can be restricted, and thus, a variation in the thickness of the sealing resin 90 can be further suppressed, and the reinforcing effect of the first support resin layer 21 by the sealing resin 90 can be further stabilized.

The convex portion 84 includes: a first convex portion 84A which is formed from the one end to the other end of the tip end 51G along the tip end 51G of the second branch portion 51B; and second convex portions 84B which are formed on both ends of the first convex portion 84A in the extending direction. The second convex portion 84B is formed on the upper surface of the second support resin layer 31 along end portions 51I on both sides of the second branch portion 51B in the width direction (a direction orthogonal to the terminal portion 53C). That is, the convex portion 84 extends along an end surface of a tip end of the second branch portion 51B and is formed so as to reach the end surface of the second branch portion 51B on both sides in the width direction. Accordingly, on both sides of the second branch portion 51B in the width direction, the wet-spreading of the liquid resin at the time of filling can be restricted, and thus, a variation in the thickness of the sealing resin 90 can be further suppressed, and the reinforcing effect of the second support resin layer 31 by the sealing resin 90 can be further stabilized.

The "first wiring body 20" and the "second wiring body 30" in the embodiments correspond to an example of the "wiring body" in the present invention. In a case where the "first wiring body 20" in the embodiments corresponds to an example of the "wiring body" in the present invention, the "first support resin layer 21" in the embodiments corresponds to an example of the "first resin layer" in the present invention, the "terminal portion 22C" in the embodiments corresponds to an example of the "first terminal portion" in the present invention, and the "second support resin layer 31" and "coating resin layer 40" in the embodiments correspond to an example of the "second resin layer" in the present invention. On the other hand, in a case where the "second wiring body 30" in the embodiments corresponds to an example of the "wiring body" in the present invention, the "first support resin layer 21" and the "second support resin layer 31" in the embodiments correspond to an example of the "first resin layer" in the present invention, in the embodiments corresponds to an example of the "terminal portion 32C" in the embodiments corresponds to an example of the "first terminal portion" in the present invention, and the "coating resin layer 40" in the embodiments corresponds to an example of the "second resin layer" in the present invention.

The "connection wiring body 50" in the embodiments corresponds to an example of the "connection wiring body" in the present invention, and the "substrate 51" in the embodiments corresponds to an example of the "substrate" in the present invention. In a case where the "first wiring body 20" in the embodiments corresponds to an example of the "wiring body" in the present invention, the "terminal portion 52C" in the embodiments corresponds to an example of the "second terminal portion" in the present invention. On the other hand, in a case where the "second wiring body 30" in the embodiments corresponds to an example of the "wiring body" in the present invention, the "terminal portion 53C" in the embodiments corresponds to an example of the "second terminal portion" in the present invention.

The "conductive adhesive layer 80" in the embodiments corresponds to an example of the "conductive adhesive layer" in the present invention. In a case where the "first wiring body 20" in the embodiments corresponds to an example of the "wiring body" in the present invention, the "tip end 51E" in the embodiments corresponds to an example of the "end portion of the substrate" in the present invention, and the "wall surface 31B" and the "wall surface 40B" in the embodiments correspond to an example of the "end portion of the second resin layer" in the present invention. On the other hand, in a case where the "second wiring body 30" in the embodiments corresponds to an example of the "wiring body" in the present invention, the "tip end 51G" in the embodiments corresponds to an example of the "the end portion of the substrate" in the present invention, and the "wall surface 40B" in the embodiments corresponds to an example of the "end portion of the second resin layer" in the present invention.

The "convex portion 82" and the "convex portion 84" in the embodiments correspond to an example of the "convex portion" in the present invention, and the "sealing resin 90" in the embodiments corresponds to an example of the "sealing resin" in the present invention. The "first convex portion 82A" and the "first convex portion 84A" in the embodiments correspond to an example of the "first convex portion" in the present invention, and the "second convex portion 82B" and the "second convex portion 84B" in the embodiments correspond to an example of the "second convex portion" in the present invention. Further, the "cut-out portion 31A" and the "cut-out portion 40A" in the embodiments correspond to an example of the "cut-out portion" in the present invention, and the "corner portion 31C" and the "corner portion 40C" in the embodiments correspond to an example of the "corner portion" in the present invention.

The "wiring body assembly 11" in the embodiments corresponds to an example of the "wiring body assembly " in the present invention, the "substrate 12" and the "cover panel 70" in the embodiments correspond to an example of the "support body" in the present invention, the "touch sensor 10" in the embodiments corresponds to an example of the "wiring structure" and the "touch sensor" in the present invention.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, the touch sensor 10 of the embodiments is the projection electrostatic capacitance type touch panel sensor formed of the electrode portion of two layers, but is not particularly limited thereto, and it is also possible to apply the present invention to a surface (capacitive coupling) electrostatic capacitance type touch sensor formed of an electrode portion of one layer.

In the embodiments described above, the wiring body assembly or the wiring structure have been described as being used in the touch panel sensor, but are not particularly limited thereto. For example, the wiring body may be used as a heater by energizing the wiring body to generate heat according to resistance heating or the like. A part of a conductor portion of the wiring body is grounded, and thus, the wiring body may be used as an electromagnetic shielding shield. The wiring body may be used as an antenna. In these case, a mounting target on which the wiring body is mounted corresponds to an example of the "support body" in the present invention.

EXPLANATIONS OF LETTERS OR NUMERALS

| 10 | touch sensor |
| 11 | wiring body assembly |
| 12 | substrate |
| 20 | first wiring body |
| 21 | first support resin layer |
| 22A | electrode |
| 22B | lead-out wire |
| 22C | terminal portion |
| 30 | second wiring body |
| 31 | second support resin layer |
| 31A | cut-out portion |
| 31B | wall surface |
| 31C | corner portion |
| 32A | electrode |
| 32B | lead-out wire |
| 32C | terminal portion |
| 40 | coating resin layer |
| 40A | cut-out portion |
| 40B | wall surface |
| 40C | corner portion |
| 50 | connection wiring body |
| 51 | substrate |
| 51A | first branch portion |
| 51B | second branch portion |
| 51C | slit |
| 51D | adhesive portion |
| 51E | tip end |
| 51F | adhesive portion |
| 51G | tip end |
| 51H | end portion |
| 51I | end portion |
| 52 | wiring |
| 52C | terminal portion |
| 53 | wiring |
| 53C | terminal portion |
| 60 | transparent adhesive layer |
| 70 | cover panel |
| 71 | transparent portion |
| 72 | shielding portion |
| 80 | conductive adhesive layer |
| 81 | conductive adhesive material |
| 81A | region |
| 81B | region |
| 82 | convex portion |
| 82A | first convex portion |
| 82B | second convex portion |
| 84 | convex portion |
| 84A | first convex portion |
| 84B | second convex portion |
| 86 | groove |
| 88 | groove |
| 90 | sealing resin |
| 1 | compression head |
| 2 | compression base |

Claims

1. A wiring body assembly comprising:

a wiring body including

a first resin layer,

a first terminal portion which is formed on one surface of the first resin layer, and
a second resin layer which is formed on the one surface of the first resin layer so that the first terminal portion is exposed;

a connection wiring body including

a substrate, and
a second terminal portion which is formed on one surface of the substrate and faces the first terminal portion; and

a conductive adhesive layer which is formed between the first terminal portion and the second terminal portion and with which the first terminal portion and the second terminal portion adhere to each other, wherein
an end portion of the substrate and an end portion of the second resin layer are separated from each other so that the first terminal portion includes an exposed portion exposed from the second resin layer and the conductive adhesive layer,
the wiring body assembly further comprises:

a convex portion which is formed on the one surface of the first resin layer so as to be in contact with the end portion of the substrate and to define a groove portion together with the one surface and the second resin layer, or which is formed on other surface of the substrate; and
a sealing resin which fills between the convex portion and the second resin layer and which covers the exposed portion of the first terminal portion, and
a following Expression (1) is satisfied:

$$H1 > H2 \ \dots(1)$$

where, H1 is a height from the one surface of the first resin layer to a distal end of the convex portion, and H2 is a height from the one surface of the first resin layer to the other surface of the substrate.

2. The wiring body assembly according to claim 1, wherein
the convex portion is integrally formed with the conductive adhesive layer on the one surface of the first resin layer so as to be in contact with the end portion of the substrate, and the convex portion is made of a conductive adhesive material of the conductive adhesive layer is made.

3. The wiring body assembly according to claim 1 or 2, wherein
a following Expression (2) is satisfied:

$$H3 \geq H1 \ \dots(2)$$

where, H3 is a thickness of the second resin layer.

4. The wiring body assembly according to any one of claims 1 to 3, wherein
the sealing resin extends in a direction intersecting with the first terminal portion, and
the convex portion is formed along a direction in which the sealing resin extends.

5. The wiring body assembly according to claim 4, wherein
the convex portion includes:

a first convex portion formed along the direction in which the sealing resin extends; and
a second convex portion formed along an end portion of the substrate in a direction intersecting with the terminal portion.

6. The wiring body assembly according to any one of claims 1 to 5, wherein
the second resin layer includes a cut-out portion in which the end portion of the substrate is disposed, the cut-out portion includes a corner portion, and the corner portion is filled with the sealing resin.

7. A wiring structure comprising:

the wiring body assembly according to any one of claims 1 to 6; and
a support body disposed on at least one surface of the wiring body.

8. A touch sensor comprising:
the wiring structure according to claim 7.

FIG. 1

# FIG. 2

FIG. 3

EP 3 429 321 A1

FIG. 4

FIG. 5

EP 3 429 321 A1

# FIG. 6

EP 3 429 321 A1

EP 3 429 321 A1

FIG. 7

# FIG. 8

FIG. 9

EP 3 429 321 A1

FIG. 10

FIG. 11

FIG. 12

EP 3 429 321 A1

FIG. 13

FIG. 14

EP 3 429 321 A1

## INTERNATIONAL SEARCH REPORT

International application No.

PCT/JP2017/009173

A. CLASSIFICATION OF SUBJECT MATTER
*H05K1/14*(2006.01)i, *G06F3/041*(2006.01)i, *G06F3/044*(2006.01)i

According to International Patent Classification (IPC) or to both national classification and IPC

B. FIELDS SEARCHED

Minimum documentation searched (classification system followed by classification symbols)
H05K1/14, G06F3/041, G06F3/044, G09F9/00

Documentation searched other than minimum documentation to the extent that such documents are included in the fields searched
Jitsuyo Shinan Koho          1922–1996   Jitsuyo Shinan Toroku Koho   1996–2017
Kokai Jitsuyo Shinan Koho    1971–2017   Toroku Jitsuyo Shinan Koho   1994–2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-107754 A  (Optrex Corp.),<br>10 April 2002 (10.04.2002),<br>paragraphs [0003], [0008], [0017] to [0019];<br>fig. 1, 2<br>(Family: none) | 1,3,4,5,7,8 |
| Y | WO 2015/114960 A1  (Sony Corp.),<br>06 August 2015 (06.08.2015),<br>paragraphs [0020] to [0038], [0064]; fig. 1, 2<br>& US 2017/0003568 A1<br>paragraphs [0053] to [0071], [0097]; fig. 1, 2 | 1-8 |
| Y | JP 2012-141690 A  (Alps Electric Co., Ltd.),<br>26 July 2012 (26.07.2012),<br>paragraphs [0024], [0025], [0048], [0049]; fig.<br>2, 13<br>(Family: none) | 8 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>      11 May 2017 (11.05.17) | Date of mailing of the international search report<br>      23 May 2017 (23.05.17) |
|---|---|
| Name and mailing address of the ISA/<br>      Japan Patent Office<br>      3-4-3,Kasumigaseki,Chiyoda-ku,<br>      Tokyo 100-8915,Japan | Authorized officer<br><br><br>Telephone No. |

Form PCT/ISA/210 (second sheet) (January 2015)

**INTERNATIONAL SEARCH REPORT**

International application No.

PCT/JP2017/009173

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2010-225845 A  (Seiko Epson Corp.),<br>07 October 2010 (07.10.2010),<br>paragraphs [0009] to [0012]; fig. 3, 4<br>(Family: none) | 1-8 |
| A | JP 6-331999 A  (Optrex Corp.),<br>02 December 1994 (02.12.1994),<br>paragraphs [0014], [0015], [0019], [0020]; fig.<br>1<br>(Family: none) | 1-8 |
| A | JP 2014-220363 A  (Panasonic Corp.),<br>20 November 2014 (20.11.2014),<br>paragraphs [0016] to [0018]; fig. 1<br>(Family: none) | 1-8 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016047909 A
- JP 2001015042 A